# EUROPEAN PATENT APPLICATION

(11) **EP 3 038 142 A1**
(43) Date of publication of application: **29.06.2016**
(21) Application number: 15199363.1
(22) Date of filing: 10.12.2015
(51) Int. Cl.: H01L 21/311

(54) **SELECTIVE NITRIDE ETCH**

(30) Priority: 18.12.2014 US 201414576020
(71) Applicant: LAM Research Corporation, Fremont, CA 94538 (US)
(72) Inventor: BERRY III, Ivan L., San Jose, CA 95134 (US); ANGELOV, Ivelin, Sunnyvale, CA 94087 (US); MARQUEZ, Linda, San Jose, CA 95125 (US); YAQOOB, Faisal, Fremont, CA 94538 (US); PARK, Pilyeon, Santa Clara, CA 95051 (US); ZHU, Helen H., Fremont, CA 94536 (US); THEDJOISWORO, Bayu Atmaja, San Jose, CA 95128 (US); LI, Zhao, Santa Clara, CA 95054 (US)
(74) Representative: Kontrus, Gerhard

(57) **Abstract**

Methods of selectively etching silicon nitride are provided. Silicon nitride layers are exposed to a fluorinating gas and nitric oxide (NO), which may be formed by reacting nitrous oxide (N₂O) and oxygen (O₂) in a plasma. Methods also include defluorinating the substrate prior to turning off the plasma to increase etch selectivity of silicon nitride.

## Description

### BACKGROUND

Semiconductor fabrication often involves patterning schemes and other processes whereby silicon nitride is selectively etched to prevent etching of other exposed surfaces of a substrate. As device geometries become smaller and smaller, high etch selectivity process are used to achieve effective plasma etching of openings in dielectric layers such as silicon nitride.

### SUMMARY

Methods of etching silicon nitride with high selectivity are provided herein. One aspect involves a method of etching silicon nitride on a substrate by (a) introducing nitrous oxide (N₂O), oxygen (O₂), and a fluorinating gas and igniting a plasma to form an etching species; and (b) exposing silicon nitride to the etching species to selectively etch the silicon nitride relative to other silicon-containing materials on the substrate. In some embodiments, the method also includes repeating (a) and (b). In various embodiments, the ratio of the oxygen to the nitrous oxide is between about 0.75:1 and about 1:1.5.

In some embodiments, the fluorinating gas includes one or more gases having the formula CHₓF_{y}, where x and y are integers between and including 0 and 4, and x + y = 4. The amount of fluorinating gas introduced may be about 10% or less of the total gas flow.

In various embodiments, the process temperature is between about 0°C and about 80°C. In some embodiments, etch selectivity of silicon nitride to dielectric is at least about 100:1. In various embodiments, the other silicon-containing materials are selected from the group consisting of silicon dioxide, silicon oxide, silicon oxy-nitride, carbon doped silicon oxide, and silicon.

In various embodiments, the method also includes (c) introducing nitric oxide (NO) to the plasma.

In various embodiments, the method also includes (c) flowing a silicon-containing compound. The silicon-containing compound may be selected from the group consisting of silane, tetrachlorosilane, tetrafluorosilane, tetraethyl orthosilicate, disilane, and tetramethylsilane. In some embodiments, the partial pressure of the silicon-containing compound is less than about 10% of the pressure of a chamber housing the substrate.

In some embodiments, the method also includes (c) defluorinating the substrate.

In various embodiments, defluorinating the substrate further includes purging a chamber housing the substrate with a purge gas. The purge gas may be selected from the group consisting of argon, nitrogen, helium, neon, krypton, and xenon.

Defluorinating the substrate may include flowing a scavenging gas. The scavenging gas may be selected from the group consisting of nitrous oxide (N₂O), nitric oxide (NO), nitrogen (N₂), carbon dioxide (CO₂), carbon monoxide (CO), oxygen (O₂), ammonia gas (NH₃), and combinations thereof.

In some embodiments, defluorinating the substrate includes turning on and leaving on, or pulsing an RF bias. In some embodiments, defluorinating the substrate includes generating a plasma of nitrous oxide (N₂O) gas and oxygen (O₂) in the absence of a fluorinating gas.

In some embodiments, the method also includes, after defluorinating the substrate, introducing an oxygen-containing gas.

Another aspect involves a method of etching a substrate by exposing the substrate to nitric oxide and a fluorinating gas and igniting a plasma to etch silicon nitride on the substrate; and defluorinating the substrate.

In various embodiments, the amount of fluorinating gas introduced is about 10% or less of the total gas flow. In various embodiments, defluorinating the substrate further includes purging a chamber housing the substrate with a purge gas. The purge gas may be selected from the group consisting of argon, nitrogen, helium, neon, krypton, and xenon. In various embodiments, defluorinating the substrate includes flowing a scavenging gas. The scavenging gas may be selected from the group consisting of nitrous oxide (N₂O), nitric oxide (NO), nitrogen (N₂), carbon dioxide (CO₂), carbon monoxide (CO), oxygen (O₂), ammonia gas (NH₃), and combinations thereof.

In various embodiments, defluorinating the substrate includes generating a plasma of nitric oxide in the absence of a fluorinating gas. In various embodiments, defluorinating the substrate includes turning on an RF bias. In some embodiments, the method includes, after defluorinating the substrate, introducing an oxygen-containing gas. In various embodiments, nitric oxide is generated by reacting nitrous oxide (N₂O) and oxygen (O₂) and igniting a plasma. In some embodiments, nitric oxide is generated by reacting nitrogen (N₂) and oxygen (O₂) and igniting a plasma.

In some embodiments, the fluorinating gas includes one or more gases having the formula CHₓF_{y}; and where x and y are integers between and including 0 and 4, and x + y = 4.

Another aspect involves an apparatus for processing semiconductor substrates, the apparatus including (a) one or more process chambers, each chamber including a showerhead and a pedestal; (b) one or more gas inlets into the process chambers and associated flow-control hardware; (c) a plasma generator; and (d) a controller having at least one processor and a memory, the memory including computer-executable instructions for: (i) introducing nitrous oxide, oxygen, and one or more fluorinating gases to at least one of the one or more process chambers, and (ii) igniting a plasma.

In various embodiments, the plasma generator is a remote plasma generator. In some embodiments, the pedestal further includes an electrostatic chuck.

In various embodiments, the computer-executable instructions for introducing the nitrous oxide, the oxygen, and the one or more fluorinating gases include instructions for flowing oxygen and nitrous oxide at a ratio between about 0.75:1 and about 1:1.5.

In some embodiments, the memory further includes computer executable instructions for flowing a silicon-containing compound. In some embodiments, the memory further includes computer executable instructions for introducing nitric oxide to the plasma. In some embodiments, the memory further includes computer executable instructions for turning off the flow of the one or more fluorinating gases.

In various embodiments, the memory further includes computer executable instructions for purging the chamber with a purge gas prior to turning off the plasma. In some embodiments, the memory further includes computer executable instructions for flowing a scavenging gas prior to turning off the plasma.

In some embodiments, the memory further includes computer executable instructions for turning on an RF bias prior to turning off the plasma. In various embodiments, the memory further includes computer executable instructions for introducing an oxygen-containing gas prior to turning off the plasma.

These and other aspects are described further below with reference to the drawings.

### BRIEF DESCRIPTION OF THE DRAWINGS

Figure 1 is a process flow diagram depicting operations of a method in accordance with disclosed embodiments.
Figures 2A-2D are schematic depictions of an example of a possible mechanism in accordance with disclosed embodiments.
Figures 3A and 3B are schematic representations of an etching scheme in accordance with disclosed embodiments.
Figures 4 and 5 are schematic diagrams of examples of process chambers for performing methods in accordance with disclosed embodiments.
Figures 6-10 are plots depicting experimental results for silicon nitride etch.

### DETAILED DESCRIPTION

In the following description, numerous specific details are set forth to provide a thorough understanding of the presented embodiments. The disclosed embodiments may be practiced without some or all of these specific details. In other instances, well-known process operations have not been described in detail to not unnecessarily obscure the disclosed embodiments. While the disclosed embodiments will be described in conjunction with the specific embodiments, it will be understood that it is not intended to limit the disclosed embodiments.

Some semiconductor manufacturing processes involve etching thin silicon nitride layers selective to underlying and/or overlying dielectric layers using a plasma. For example, silicon nitride layers may be etched during fabrication of a damascene structure or contact. During manufacture of such structures, features such as contacts, vias, conductor lines, etc., are formed by etching dielectric materials such as oxide layers. Various conventional silicon nitride etch process involve ion bombardment but may have reduced selectivity. Silicon nitride may be used as an etch stop layer in some fabrication processes.

Provided herein are methods of isotropically selectively etching silicon nitride using an efficient etch chemistry. Methods involve etching using nitric oxide (NO), which may be formed by reacting oxygen (O₂) with nitrous oxide (N₂O), and fluorinating gas chemistry with plasma to etch silicon nitride with high selectivity to silicon oxide and silicon (including polysilicon, amorphous silicon, and crystalline silicon). Methods described herein achieve etch selectivity greater than about 50:1 or greater than about 100:1. The methods described herein may be used to, for example, etching silicon nitride layers after a silicon nitride layer is used as an etch stop layer.

The disclosed embodiments are useful in manufacturing multilayer structures which include various dielectric, semiconductor, or metal layers. Dielectric layers include: silicon nitride, silicon oxy-nitride, silicon dioxide, doped silicon oxide such as fluorinated silicon oxide (FSG), silicate glasses such as boron phosphate silicate glass (BPSG) and phosphate silicate glass (PSG), atomic layer deposited oxides of silicon, atomic layer deposited layers of silicon nitride, organic siloxane polymer, carbon-doped silicate glass, silsequioxane glass, fluorinated carbon-doped silicate glass, diamond-like amorphous carbon, c-doped silica glass, or other suitable dielectric materials. Semiconductor layers include: silicon, silicon germanium, and germanium. Such multi-layers can overlie an intermediate layer such as a barrier layer and a conductive or semiconductive layer such as polycrystalline silicon, metals such as aluminum, copper, titanium, tungsten, molybdenum, or alloys thereof; nitrides such as titanium nitride; and metal silicides such as titanium silicide, cobalt silicide, tungsten silicide, molybdenum silicide, etc.

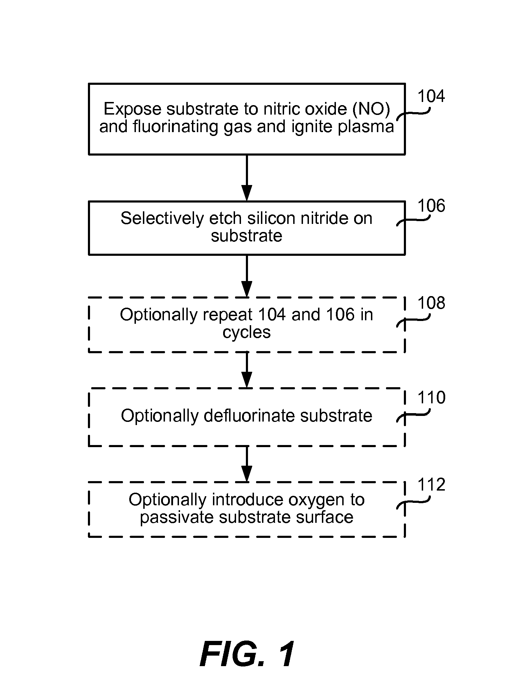

Figure 1 is a process flow diagram depicting operations of a method in accordance with disclosed embodiments. The method described in Figure 1 involves selectively etching silicon nitride on a substrate by exposing the substrate to a plasma including excited state nitric oxide (NO* as used herein) and a fluorinating gas.

Various species may be present in a plasma, such as ions, electrons, radicals, neutral species, meta-stable species, and other species. NO* is more chemically active than ground state NO, which is a free radical. In some embodiments, NO* is the active species of nitric oxide involved in the etching process as described herein. A person of ordinary skill in the art would understand that plasma as described herein includes various species as described above, and that some of these species participate in the etching process.

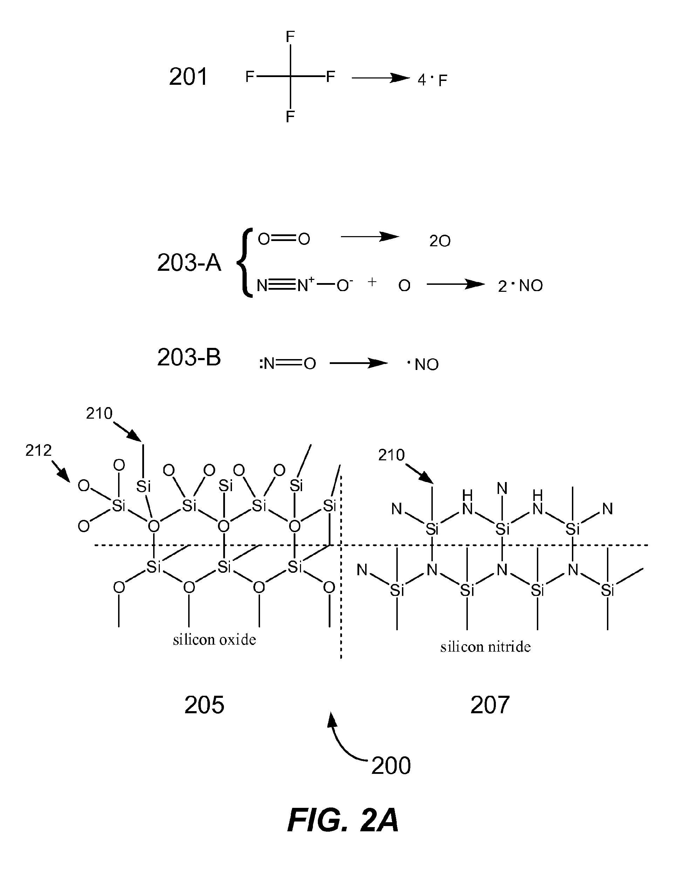

Operations 104 and 106 of Figure 1 will be described together below with Figures 2A-2D. Figures 2A-2D depict schematic representations of an example chemical mechanism for etching silicon nitride in accordance with disclosed embodiments. Figure 2A also depicts various reactions 201, 203-A, and 203-B that may occur during operation 104.

Process conditions for the method described with respect to Figure 1 depend on the substrate size, substrate composition, amounts of excited state nitric oxide (NO*) and fluorinating gas, chamber volume, and types of plasma processing tools used. In certain embodiments, the method in Figure 1 may be performed at a temperature between about 0°C and about 80°C, or between about 0°C and about 20°C, or between about 5°C and about 20°C. In some embodiments, the temperature is about 10°C. The temperature may be the substrate temperature, which may be coupled with the pedestal temperature. The pedestal temperature may be used as a proxy for substrate temperature for the disclosed embodiments. In some embodiments, the temperature may be higher or lower depending on the chamber volume, amounts of NO* and fluorinating gas, and plasma processing conditions.

In various embodiments, an inert gas may optionally be flowed during the operations of Figure 1. Example inert gases include argon, helium, neon, krypton, nitrogen, and xenon. The pressure of the chamber may depend on the type of plasma chamber. The chamber pressure may be maintained at a level suitable for sustaining a plasma in the chamber. In general, without being bound by a particular theory, too low a chamber pressure may lead to insufficient NO* formation, which may result in reduced etch rate and reduced selectivity, while too high a pressure may lead to either excessive NO* formation which quenches the etch rate by surface saturation of the substrate with chemisorbed NO, or by NO depletion when NO₂ or NOF is formed as a byproduct.

In various embodiments, a silicon-containing gas may be flowed in the background during the method of Figure 1. Example silicon-containing gases include silane (SiH₄), tetrafluorosilane (SiF₄), tetrachlorosilane (SiCl₄), tetraethyl orthosilicate (TEOS), disilane (Si₂H₆), and tetramethylsilane ((CH₃)₄Si). In some embodiments, the amount of the silicon-containing gas is less than about 10%, or less than about 5% of the total chamber pressure.

The method of Figure 1 may be performed on a substrate, such as a semiconductor substrate. The substrate may be a silicon wafer, e.g., 200-mm wafer, 300-mm wafer, 450-mm wafer, including wafers having one or more layers of material such as dielectric, conducting, or semi-conducting material deposited thereon. For example, the substrate may be a silicon wafer with at least one silicon nitride and at least one silicon oxide layer deposited thereon. Figure 2A depicts an example of a substrate 200 with silicon oxide 205 and silicon nitride 207 deposited thereon. In some embodiments, the substrate 200 may include silicon oxide 205 or silicon nitride 207 or silicon layers (not shown) that have been patterned. It is noted that although the oxide 205 and nitride 207 layers are depicted to be adjacent to each other horizontally, the nitride and oxide may not necessarily be adjacent to each other in a horizontal orientation. In some embodiments, a nitride and oxide layer may be adjacent in any orientation and additionally may not be physically adjacent to each other but may have some other material or materials separating them. A surface of the substrate 200 may be a sidewall of a feature. Note that silicon oxide 205 may include various Si-O bonds 212 and also possibly silicon dangling bonds 210. Likewise, a silicon nitride layer 207 may include some dangling bonds 210. Dangling bonds are also described below with respect to defluorination processes. The dotted line represents boundaries, whereby the horizontal line depicts an amount of silicon nitride to be etched and the vertical line depicts the interface between a silicon oxide 205 and silicon nitride layer 207. In some embodiments, one or more of the boundaries may not present.

The substrate 200 may also include various features. Features can be characterized by one or more of narrow and/or re-entrant openings, constrictions within the feature, and high aspect ratios. In some embodiments, the feature may have an aspect ratio of at least about 2:1, at least about 10:1, at least about 20:1, at least about 50:1 or higher. The feature hole or feature slit may also have a dimension near the opening, e.g., an opening diameter or line width, or opening width, or critical dimension, of less than about 40 nm, also known as feature widths less than 1x nm. In some embodiments, the feature may be a narrow trench. In some embodiments, a trench may have a width between about 20 nm and about 130 nm. The feature can be referred to as an unfilled feature or simply a feature.

In operation 104, the substrate is exposed to NO and a fluorinating gas, and a plasma is ignited. In various embodiments, the plasma may be an inductively coupled plasma, a capacitively coupled plasma, or a microwave excited plasma. In some embodiments, plasma density of a capacitively coupled plasma may be less than the plasma density in an inductively coupled plasma. In some embodiments, the plasma in a capacitively coupled plasma may have higher energy than in an inductively coupled plasma. In various embodiments, performing operations according to disclosed embodiments with an inductively coupled plasma may be more efficient.

The fluorinating gas may be any suitable fluorine-containing etchant, such as fluorine (F₂), tetrafluorocarbon (CF₄), hexafluoroethane (C₂F₆), hexafluoropropylene (C₃F₆), octafluoropropane (C₃F₈), 1,3-hexafluorobutadiene (C₄F₆), octafluorocyclobutane (C₄F₈), perfluorocyclopentene (C₅F₈), silicon hexafluoride (SF₆), and nitrogen trifluoride (NF₃). In some embodiments, a hydrogen-containing fluorinating gas having the formula CHₓF_{y} (where x = 1, 2, or 3, and y = 4 - x, or where x + y = 4 and x and y are integers between and including 0 and 4) may be added in operation in addition to the fluorinating gas. For example, the following hydrogen-containing fluorocarbons could be added in addition to the fluorinating gas: CHF₃, CH₂F₂, and CH₃F.

When the plasma is ignited, the fluorinating species forms fluorine radicals. For example, as shown in 201 of Figure 2A, a fluorinating gas tetrafluorocarbon (CF₄) may be excited by the plasma to form fluorine radicals (•F).

Process gases also include NO, which may be directly added to the chamber or formed by a reaction using two or more reactants. In various embodiments, NO, available from various manufacturers, is introduced to the process chamber (see 203-B) and excited upon ignition of the plasma. In various embodiments, NO may be formed by introducing nitrous oxide (N₂O) and oxygen (O₂) to the chamber in lieu of NO. In some embodiments, a combination of N₂O, O₂, and NO are introduced to the chamber together.

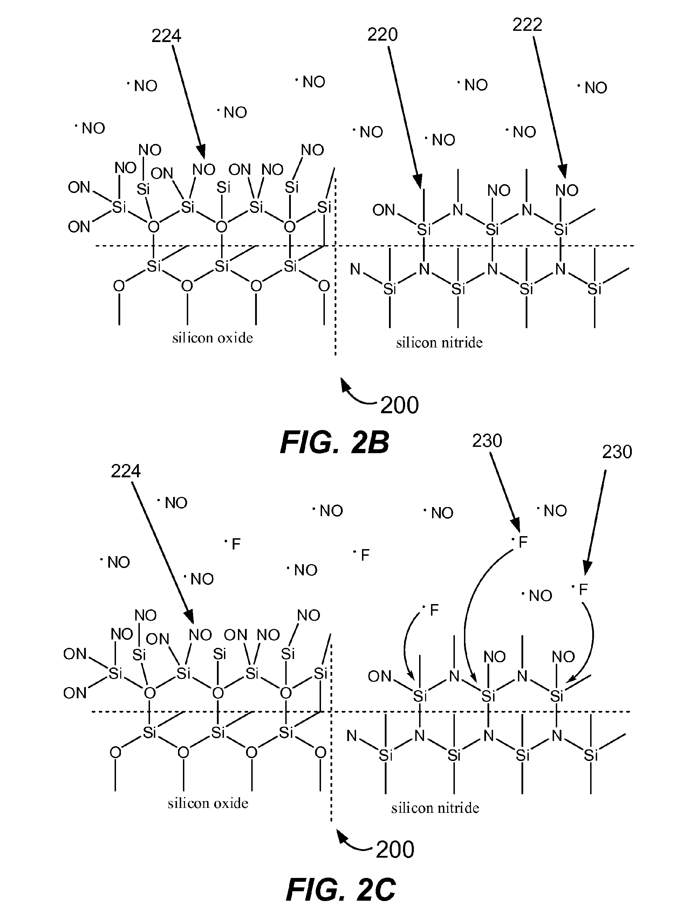

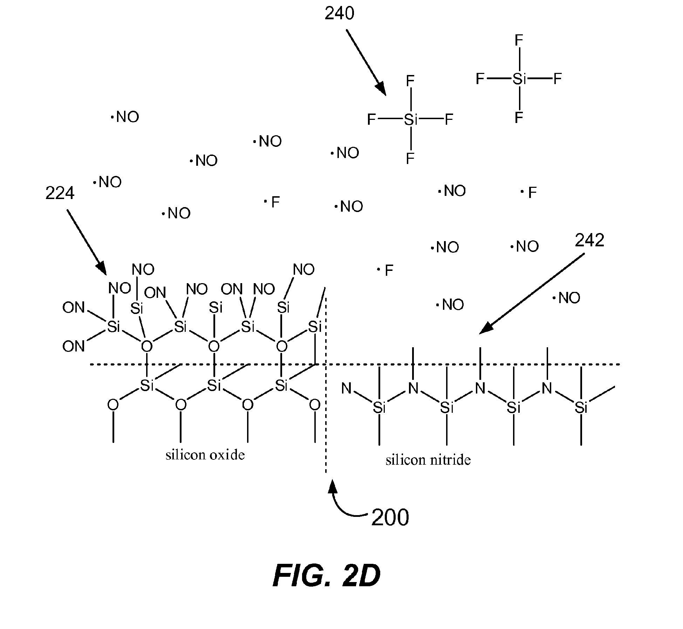

Without being bound by a particular theory, it is believed that the plasma may excite oxygen to form atomic oxygen (O) in the chamber (shown in 203-A of Figure 2 and in Reaction 1 below) and atomic oxygen may react with N₂O to form NO as shown in 203-A and in Reaction 2 below. In some embodiments, N₂O may also be excited to form NO (Reaction 3).

O₂ → 20 Rxn. 1

O + N₂O → 2NO Rxn. 2

N₂O + *e*⁻ → NO + N Rxn. 3

The flow rates are controlled such that a competing reaction between N₂O and O₂ to form nitrogen oxide (NO₂) is mitigated. In some embodiments, the ratio of the flow rate of oxygen gas to the flow rate of nitrous oxide gas may be between about 0.75:1 and about 1:1.5, or between about 0.8:1 and about 1:1.2, or about 1:1. The flow rate of fluorinating gas into the chamber may be an order of magnitude less than that of nitrous oxide. In some embodiments, the flow rate of the fluorinating gas into the chamber may be about 10% or less of the total gas flow into the chamber. Note that flow rates of gases depend on the size of the substrate, the type of plasma chamber, the power settings, vacuum pressure, dissociation rate of plasma source, and other factors.

The plasma may excite NO, thereby forming excited state NO*, which subsequently interacts with the surface of the substrate. In some embodiments, some ground state NO may be present in the chamber in small amounts. Excited state NO* may be more reactive or more chemically active than NO radicals in the ground state. NO added as a gas into the chamber may be excited by plasma to form NO*, which may react with the surface of the substrate. Without being bound by a particular theory, it is believed that NO may chemisorb onto the surface of the substrate by replacing nitrogen or oxygen atoms originally bonded to silicon, as described below.

The formation and/or presence of NO* may be controlled by modulating conditions, such as plasma power, chamber pressure, temperature, and flow rates, to thereby increase the concentration of NO* in the chamber. An increased concentration of NO* may favor more NO chemisorbed onto a silicon oxide or silicon surface than on a silicon nitride surface. The relative chemisorption of NO on silicon oxide, silicon, and silicon nitride may also be controlled using these parameters. Note that these parameters are also modulated such that a competing chemical reaction between NO and fluorine radicals to form NOF is avoided. Although silicon oxide layers are described in the disclosed embodiments, it is understood that any dielectric silicon oxide or silicon layer may be present instead, such as polysilicon, crystalline silicon, amorphous silicon, silicon dioxide, silicon oxy-nitride, and carbon-doped silicon oxide.

The flow rates and plasma conditions may be controlled such that NO* generated when the plasma is ignited may chemisorb onto most of the silicon oxide surface and/or silicon surface. Figure 2A depicts a substrate 200 with silicon oxide 205 and silicon nitride 207. Silicon oxide includes various Si-O bonds 212 at the surface as well as some silicon dangling bonds 210. Silicon nitride may also include some silicon dangling bonds 210. Figure 2B depicts NO bonded to silicon on most or the entire surface of the silicon oxide layer at 224, whereas NO is only bonded to some silicon on the silicon nitride layer at 222. In some embodiments, NO* concentration is such that silicon oxide is mostly chemisorbed, but silicon nitride has less chemisorption of NO. That is, less NO may be chemisorbed onto the surface of a silicon nitride layer than on a silicon oxide or silicon layer. This can be controlled by varying the relative conditions in the chamber, including power of the plasma, pressure of the chamber, and temperature. The conditions are modulated to sufficiently passivate a silicon oxide layer and/or silicon layer with NO, but not completely passivate a silicon nitride layer. For example, too high a pressure may cause both silicon nitride and silicon oxide surfaces to become passivated, while at too low a pressure, both the oxide and nitride surfaces are not completely passivated. NO chemisorption may increase etch rate when the surface is partially passivated, but etch rate may be reduced when the surface is fully passivated. In some embodiments, highly selective etch of silicon nitride to silicon oxides occurs when the silicon nitride surface is partially passivated, while the silicon oxide surfaces are fully passivated.

During operation 104, in some embodiments, the electron temperature may be modulated to prevent dissociation of nitrous oxide. The electron temperature may be defined as the temperature of the Maxwell Boltzmann distribution for electrons in a plasma. Electron temperature is correlated with the density of the plasma generated. Toggling plasma parameters may modulate electron temperature. Too high an electron temperature may cause nitrous oxide to dissociate into atomic or diatomic oxygen, and atomic or diatomic nitrogen. Accordingly, in some embodiments, nitrous oxide is controlled during operation 104 to form NO without dissociating. Similarly, electron temperature is maintained to prevent dissociation of NO.

Without being bound by a particular theory, it is believed that once NO chemisorbs to a silicon atom, the NO begins to desorb, such that once NO is desorbed, a silicon dangling bond may remain (as shown in 220), which may then be attacked by a fluorine radical, as shown in 230 in Figure 2C. This may form a good leaving group, thereby cleaving an Si-N bond and etching the SiN layer.

The conditions of the plasma are controlled such that more chemisorption of NO occurs on the silicon oxide and/or silicon layers than on the silicon nitride layers. These conditions include plasma power, plasma type, and plasma frequency. In various embodiments described herein, the plasma power is about 500 W - 5000 W, for example, about 1500 W - 2000 W.

In operation 106, the substrate is exposed to the plasma to selectively etch silicon nitride. Fluorine radicals generated in the plasma from the fluorinating gas as shown in 230 of Figure 2C, react with silicon to remove silicon atoms from the surface of the silicon nitride on the substrate 200. A silicon oxide layer may not be etched as quickly as a SiN layer because silicon atoms on the silicon oxide layer may maintain bonded to NO (224) under the conditions of the chamber. That is, NO may form a protection layer over the surface of silicon oxide while silicon nitride is etched, thereby increasing selectivity of the silicon nitride etch. Figure 2D depicts an example of a substrate 200 where the silicon nitride layer was etched in Figure 2C and silicon oxide remains, thereby showing high etch selectivity for SiN. Upon etching, SiF₄ may be pumped out of the chamber (240). Layers of the silicon nitride are etched selectively as shown at 242, noting that various bonds connecting silicon and nitrogen atoms in the film are broken as the layer is etched. Note that although NO may have desorbed on the surface of the silicon oxide layer, NO may continue to chemisorb onto the surface of the silicon oxide (224), since the plasma excites NO continuously to form NO*. The etch rate may be modulated by adjusting conditions of the process chamber.

In some embodiments, in operation 108, operations 104 and 106 may be optionally repeated in cycles to selectively etch silicon nitride.

In various embodiments, after the silicon nitride is selectively etched and prior to turning off the plasma, the substrate is optionally defluorinated in operation 110. Defluorination is defined as a process of removing or purging fluorine from the chamber or from the substrate. Defluorination may prevent etching of the oxide once the plasma is turned off. Without being bound by a particular theory, it is believed that defluorination may prevent fluorine radicals from binding onto silicon atoms on the silicon oxide layer, or may remove bonded fluorine on the silicon oxide layer to reduce oxide loss after the plasma is turned off. Without defluorination, NO bonded on a silicon oxide layer may desorb, making silicon oxide susceptible to etching by remaining fluorine radicals in the chamber. Defluorination methods described herein may thereby increase etch selectivity for silicon nitride to silicon oxide. Defluorination may be performed after exposing silicon nitride to a plasma including NO* and a fluorinating gas. In some embodiments, defluorination may be performed after other techniques for generating NO and a fluorinating gas are used to etch silicon nitride. For example, NO may be formed by reacting N₂ and O₂, and a silicon nitride layer on a substrate may be exposed to N₂, O₂, and a fluorinating gas while igniting a plasma.

The substrate may be defluorinated by pumping fluorine from the chamber, such as with a purge gas. In some embodiments, the purge gas is an inert gas, such as helium or argon. The substrate may be defluorinated by using a scavenging gas. The scavenging gas bonds to silicon dangling bonds instead of fluorine and protects the surface of the silicon oxide from being etched. Scavenging gases may include NO, NO₂, N₂, CO, CO₂, O₂, NH₃, and combinations thereof. In some embodiments, the substrate may be defluorinated by generating a plasma using N₂O gas and O₂ in the absence of a fluorine-containing gas.

In some embodiments, the substrate is defluorinated by applying an RF bias on the substrate. In some embodiments, the pedestal is an electrostatic chuck. Without being bound by a particular theory, it is believed that applying an RF bias helps remove chemisorbed fluorine on the surface of the silicon oxide without etching the silicon oxide layer. One or more of these methods may be used together to defluorinate the substrate. For example, a scavenging gas may be introduced while the RF bias is turned on. Once defluorinated, the plasma may be turned off and excess oxide loss is avoided. In some embodiments, the bias may also be pulsed to modulate defluorination and reduce faceting of the top of features or trenches. As an example, the bias may be pulsed at a frequency between about 500Hz and about 2000Hz with duty cycles between about 1% and about 100%.

In various embodiments, during defluorination in operation 110, the plasma is on to continuously passivate the surface until any residual fluorine concentration is reduced and/or eliminated. In some embodiments, after defluorination, the surface of a silicon oxide layer on the substrate is passivated with oxygen in operation 112. An oxygen-containing gas may be introduced to the chamber after defluorination but before the plasma is turned off to recover silicon oxide without contaminating it. In some embodiments, an oxygen-containing gas may also protect an exposed silicon layer on the substrate. In various embodiments, defluorination may be performed in combination with oxygen passivation. For example, oxygen may be used as an oxygen-containing gas. In some embodiments, operations 110 and 112 are repeated to maintain high etch selectivity to silicon nitride and avoid etching silicon oxide or silicon layers exposed on the substrate.

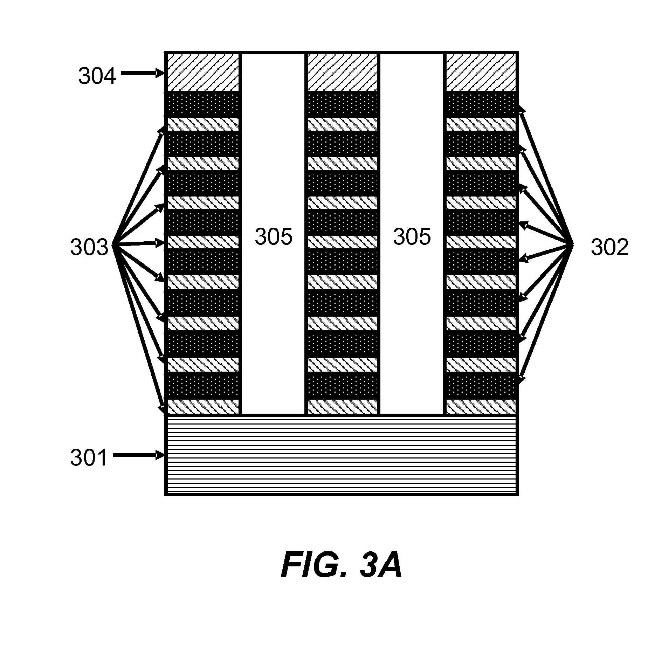

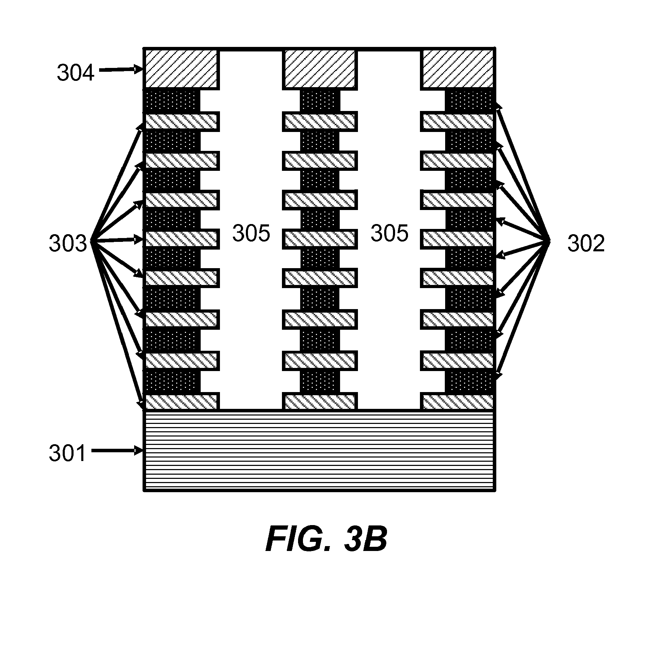

Figures 3A and 3B provide an example of a patterning scheme for which disclosed embodiments may be performed. Figure 3A shows a cross section of a semiconductor substrate with a silicon or silicon layer 301, silicon nitride layers 302, silicon dioxide layers 303, and a mask layer 304. The cross section depicted in Figure 3A has already been partially patterned to form two trenches 305. Although a silicon layer 301 is depicted, other matter may be present on a substrate, such as dielectric material, semiconductor material, or conductor material.

Figure 3B shows the substrate whereby exposed portions of silicon nitride layers 302 below the mask layer 304 were etched selectively to the silicon dioxide layers 303, to the mask layer 304, and to the substrate layer 301. A method such as the one described above with respect to Figure 1 may be used to isotropically etch silicon nitride with high selectivity to form a structure such as shown in Figure 3B.

### APPARATUS

In some embodiments, disclosed embodiments are performed in a process chamber, such as a plasma chamber. The method may be performed in an inductively-coupled plasma or a capacitively-coupled plasma chamber.

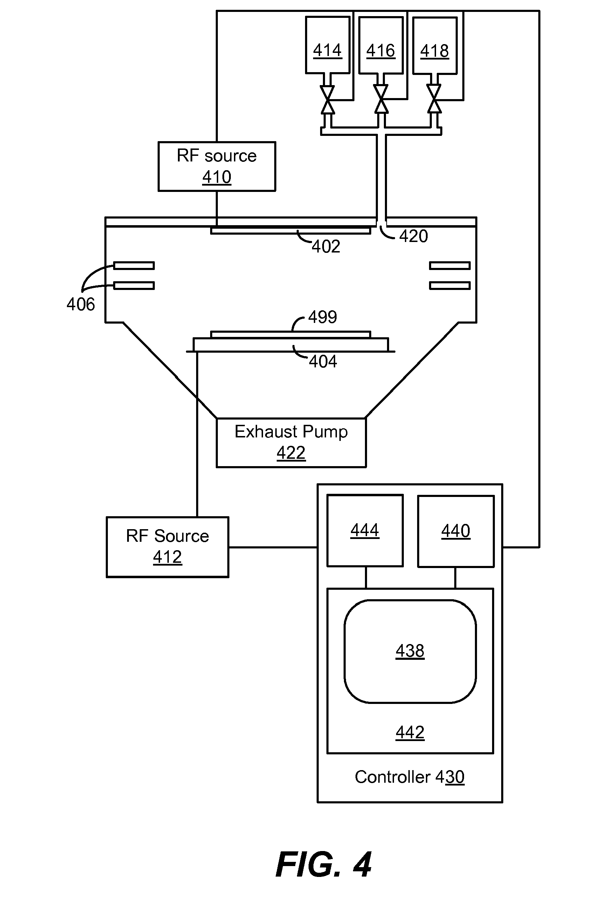

Figure 4 is a schematic depiction of an example of an inductively-coupled plasma etch chamber according to various embodiments. The plasma etch chamber 400 includes an upper electrode 402 and a lower electrode 404 between which a plasma may be generated. A substrate 499 having a silicon nitride film thereon and as described above may be positioned on the lower electrode 404 and may be held in place by an electrostatic chuck (ESC). Other clamping mechanisms may also be employed. The plasma etch chamber 400 includes plasma confinement rings 406 that keep the plasma over the substrate and away from the chamber walls. Other plasma confinement structures, e.g. as a shroud that acts an inner wall, may be employed. In some embodiments, the plasma etch chamber may not include any such plasma confinement structures.

In the example of Figure 4, the plasma etch chamber 400 includes two RF sources with RF source 410 connected to the upper electrode 402 and RF source 412 connected to the lower electrode 404. Each of the RF sources 410 and 412 may include one or more sources of any appropriate frequency including 2 MHz, 13.56 MHz, 27 MHz, and 60 MHz. Gas may be introduced to the chamber from one or more gas sources 414, 416, and 418. For example, the gas source 414 may include an inert gas, the gas source 416 may include nitric oxide (NO), or nitrous oxide (N₂O) and oxygen (O₂), and the gas source 418 may include a fluorinating gas. In another example, the gas source 414 may include an inert gas, the gas source 416 may include a nitrous oxide (N₂O) and oxygen (O₂), and the gas source 418 may include a fluorinating gas (e.g., CF₄) and a hydrogen-containing fluorinating gas (e.g., CH₂F₂). The gas source may also include a silicon containing gas (e,g., SiH₄). Gas may be introduced to the chamber through inlet 420 with excess gas and reaction byproducts exhausted via exhaust pump 422.

One example of a plasma etch chamber that may be employed is a 2300® Flex™ reactive ion etch tool available from Lam Research Corp. of Fremont, CA. Further description of plasma etch chambers may be found in U.S. Patent Nos. 6,841,943 and 8,552,334, which are herein incorporated by reference for all purposes.

Returning to Figure 4, a controller 430 is connected to the RF sources 410 and 412 as well as to valves associated with the gas sources 414, 416, and 418, and to the exhaust pump 422. In some embodiments, the controller 430 controls all of the activities of the plasma etch chamber 400. The controller 430 may execute control software 438 stored in mass storage device 440, loaded into memory device 442, and executed on processor 444. Alternatively, the control logic may be hard coded in the controller 430. Applications Specific Integrated Circuits, Programmable Logic Devices (e.g., field-programmable gate arrays, or FPGAs) and the like may be used for these purposes. In the following discussion, wherever "software" or "code" is used, functionally comparable hard coded logic may be used in its place. Control software 438 may include instructions for controlling the timing, mixture of gases, gas flow rates, chamber pressure, chamber temperature, wafer temperature, RF frequency, RF power levels, substrate pedestal, chuck and/or susceptor position, and other parameters of a particular process performed by plasma etch chamber 400. Control software 438 may be configured in any suitable way. For example, various process tool component subroutines or control objects may be written to control operation of the process tool components used to carry out various process tool processes. The control software 438 may be coded in any suitable computer readable programming language.

In some embodiments, the control software 438 may include input/output control (IOC) sequencing instructions for controlling the various parameters described above. Other computer software and/or programs stored on mass storage device 440 and/or memory device 442 associated with the controller 430 may be employed in some embodiments. Examples of programs or sections of programs for this purpose include a process gas control program, a pressure control program, and RF source control programs.

A process gas control program may include code for controlling gas composition (e.g., oxidizing and reducing gases as described herein) and flow rates and optionally for flowing gas into a chamber prior to deposition to stabilize the pressure in the chamber. A pressure control program may include code for controlling the pressure in the chamber by regulating, for example, a throttle valve in the exhaust system of the chamber, a gas flow into the chamber, etc. A RF source control program may include code for setting RF power levels applied to the electrodes in accordance with the embodiments herein.

In some embodiments, there may be a user interface associated with the controller 430. The user interface may include a display screen, graphical software displays of the apparatus and/or process conditions, and user input devices such as pointing devices, keyboards, touch screens, microphones, etc.

In some embodiments, parameters adjusted by controller 430 may relate to process conditions. Non-limiting examples include process gas composition and flow rates, temperature, pressure, plasma conditions (such as RF bias power levels), pressure, temperature, etc. These parameters may be provided to the user in the form of a recipe, which may be entered utilizing the user interface.

Signals for monitoring the process may be provided by analog and/or digital input connections of system controller 430 from various process tool sensors. The signals for controlling the process may be output on the analog and digital output connections of the plasma etch chamber 400. Non-limiting examples of sensors that may be monitored include mass flow controllers, pressure sensors (such as manometers), thermocouples, etc. Appropriately programmed feedback and control algorithms may be used with data from these sensors to maintain process conditions.

The controller 430 may provide program instructions for implementing the above-described selective etch processes. The program instructions may control a variety of process parameters, such as RF bias power level, pressure, temperature, etc. The instructions may control the parameters to selectively etch silicon nitride films according to various embodiments described herein.

A controller 430 will typically include one or more memory devices and one or more processors configured to execute the instructions so that the apparatus will perform a method in accordance with disclosed embodiments. Machine-readable media including instructions for controlling process operations in accordance with disclosed embodiments may be coupled to the controller 430, for example as describe above.

In some implementations, the controller 430 may be or form part of a system controller that is part of a system, which may be part of the above-described examples. Such systems can include semiconductor processing equipment, including a processing tool or tools, chamber or chambers, a platform or platforms for processing, and/or specific processing components (a wafer pedestal, a gas flow system, etc.). These systems may be integrated with electronics for controlling their operation before, during, and after processing of a semiconductor wafer or substrate. The electronics may be referred to as the "controller," which may control various components or subparts of the system or systems. The system controller, depending on the processing conditions and/or the type of system, may be programmed to control any of the processes disclosed herein, including the delivery of processing gases, temperature settings (e.g., heating and/or cooling), pressure settings, vacuum settings, power settings, radio frequency (RF) generator settings, RF matching circuit settings, frequency settings, flow rate settings, fluid delivery settings, positional and operation settings, wafer transfers into and out of a tool and other transfer tools and/or load locks connected to or interfaced with a specific system.

Broadly speaking, the system controller may be defined as electronics having various integrated circuits, logic, memory, and/or software that receive instructions, issue instructions, control operation, enable cleaning operations, enable endpoint measurements, and the like. The integrated circuits may include chips in the form of firmware that store program instructions, digital signal processors (DSPs), chips defined as application specific integrated circuits (ASICs), and/or one or more microprocessors, or microcontrollers that execute program instructions (e.g., software). Program instructions may be instructions communicated to the system controller in the form of various individual settings (or program files), defining operational parameters for carrying out a particular process on or for a semiconductor wafer or to a system. The operational parameters may, in some embodiments, be part of a recipe defined by process engineers to accomplish one or more processing steps during the fabrication of one or more layers, materials, metals, oxides, silicon, silicon dioxide, surfaces, circuits, and/or dies of a wafer.

The system controller, in some implementations, may be a part of or coupled to a computer that is integrated with, coupled to the system, otherwise networked to the system, or a combination thereof. For example, the system controller may be in the "cloud" or all or a part of a fab host computer system, which can allow for remote access of the wafer processing. The computer may enable remote access to the system to monitor current progress of fabrication operations, examine a history of past fabrication operations, examine trends or performance metrics from a plurality of fabrication operations, to change parameters of current processing, to set processing steps to follow a current processing, or to start a new process. In some examples, a remote computer (e.g. a server) can provide process recipes to a system over a network, which may include a local network or the Internet. The remote computer may include a user interface that enables entry or programming of parameters and/or settings, which are then communicated to the system from the remote computer. In some examples, the system controller receives instructions in the form of data, which specify parameters for each of the processing steps to be performed during one or more operations. It should be understood that the parameters may be specific to the type of process to be performed and the type of tool that the system controller is configured to interface with or control. Thus as described above, the system controller may be distributed, such as by including one or more discrete controllers that are networked together and working towards a common purpose, such as the processes and controls described herein. An example of a distributed controller for such purposes would be one or more integrated circuits on a chamber in communication with one or more integrated circuits located remotely (such as at the platform level or as part of a remote computer) that combine to control a process on the chamber.

Without limitation, example systems may include a plasma etch chamber or module, a deposition chamber or module, a spin-rinse chamber or module, a metal plating chamber or module, a clean chamber or module, a bevel edge etch chamber or module, a physical vapor deposition (PVD) chamber or module, a chemical vapor deposition (CVD) chamber or module, an atomic layer deposition (ALD) chamber or module, an atomic layer etch (ALE) chamber or module, an ion implantation chamber or module, a track chamber or module, a strip chamber or module, and any other semiconductor processing systems that may be associated or used in the fabrication and/or manufacturing of semiconductor wafers.

As noted above, depending on the process step or steps to be performed by the tool, the system controller might communicate with one or more of other tool circuits or modules, other tool components, cluster tools, other tool interfaces, adjacent tools, neighboring tools, tools located throughout a factory, a main computer, another controller, or tools used in material transport that bring containers of wafers to and from tool locations and/or load ports in a semiconductor manufacturing factory.

The apparatus/process described herein may be used in conjunction with lithographic patterning tools or processes, for example, for the fabrication or manufacture of semiconductor devices, displays, LEDs, photovoltaic panels and the like. Typically, though not necessarily, such tools/processes will be used or conducted together in a common fabrication facility. Lithographic patterning of a film typically includes some or all of the following operations, each operation enabled with a number of possible tools: (1) application of photoresist on a workpiece, i.e., substrate, using a spin-on or spray-on tool; (2) curing of photoresist using a hot plate or furnace or UV curing tool; (3) exposing the photoresist to visible or UV or x-ray light with a tool such as a wafer stepper; (4) developing the resist so as to selectively remove resist and thereby pattern it using a tool such as a wet bench; (5) transferring the resist pattern into an underlying film or workpiece by using a dry or plasma-assisted etching tool; and (6) removing the resist using a tool such as an RF or microwave plasma resist stripper.

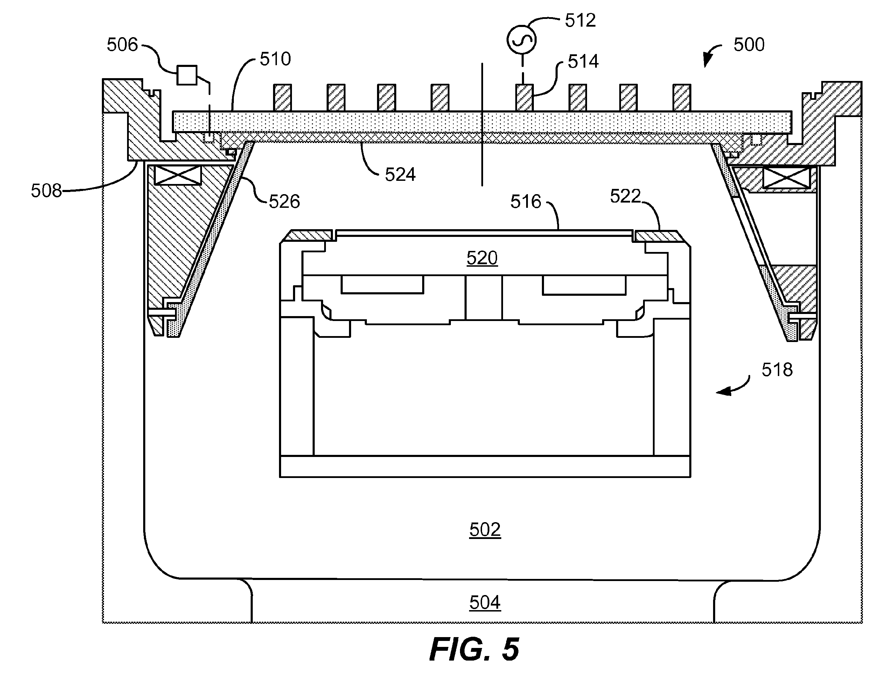

Alternatively, the process of the disclosed embodiments can be carried out in a capacitively-coupled plasma etch chamber such as chamber 500 shown in Figure 5. The chamber 500 includes an interior 502 maintained at a desired vacuum pressure by a vacuum pump connected to an outlet 504 in a lower wall of the chamber. Etching gas can be supplied to a showerhead arrangement to supply gas from gas supply 506 to a plenum 508 extending around the underside of a dielectric window 510. A high density plasma can be generated in the chamber by supplying RF energy from an RF source 512 to an external RF antenna 514 such as a planar spiral coil having one or more turns outside the dielectric window 510 on top of the chamber. The plasma generating source can be part of a modular mounting arrangement removably mounted in a vacuum tight manner on the upper end of the chamber.

A semiconductor substrate 516 such as a wafer is placed within the chamber on the substrate support 518 such as a cantilever chuck arrangement removably supported by a modular mounting arrangement from a sidewall of the chamber. The substrate support 518 can include a bottom electrode for supplying an RF bias to the substrate during processing thereof.

The substrate support 518 is at one end of a support arm mounted in a cantilevel fashion such that the entire substrate support/support arm assembly can be removed from the chamber by passing the assembly through an opening in the sidewall of the chamber. The substrate support 518 can include a chucking apparatus such as an electrostatic chuck 520 and the substrate can be surrounded by a dielectric focus ring 522. The chuck can include an RF biasing electrode from applying an RF bias to the substrate during an etching process. The etching gas supplied by gas supply 506 can flow through channels between the window 510 and an underlying gas distribution plate 524 and enter the interior 502 through gas outlets in the plate 524. The chamber can also include a cylindrical or conical heated liner 526 extending from the plate 524.

A system controller as described above with respect to Figure 4 may be implemented with the etch chamber in Figure 5.

### EXPERIMENTAL

### EXPERIMENT 1: PRESSURE

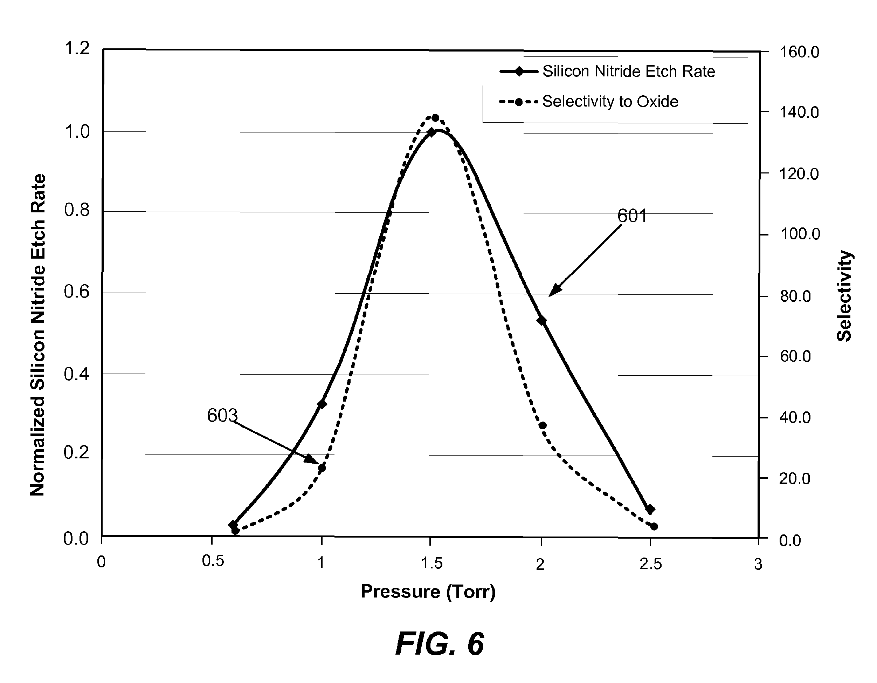

An experiment was conducted to evaluate the etch rate and etch selectivity of silicon nitride relative to chamber pressure. Substrates with silicon nitride and TEOS deposited silicon oxide were provided to a process chamber. In each trial, the substrate was exposed to nitrous oxide (N₂O), oxygen (O₂), and tetrafluorocarbon (CF₄) with a plasma. The etch rate of silicon nitride was measured and etch selectivity to silicon oxide was calculated for processes operated at a pressure of about 0.6 Torr, 1.0 Torr, 1.5 Torr, 2.0 Torr, and 2.5 Torr. The results are plotted in Figure 6. The curve 601 depicts the normalized silicon nitride etch rate relative to pressure. The curve 603 depicts the trend for silicon nitride etch selectivity to silicon oxide relative to pressure. Note that both the peak etch rate and highest selectivity were observed at 1.5 Torr. Etch rate and selectivity dropped significantly at 0.5 Torr and 2.5 Torr. Without being bound by a particular theory, it is believed that at pressures about 1 Torr or less there is insufficient NO* concentration at the substrate surface to enhance nitride etch rate. For pressures of about 2 Torr or greater, the concentration of NO* is so high, that the silicon nitride surface becomes passivated.

### EXPERIMENT 2: POWER

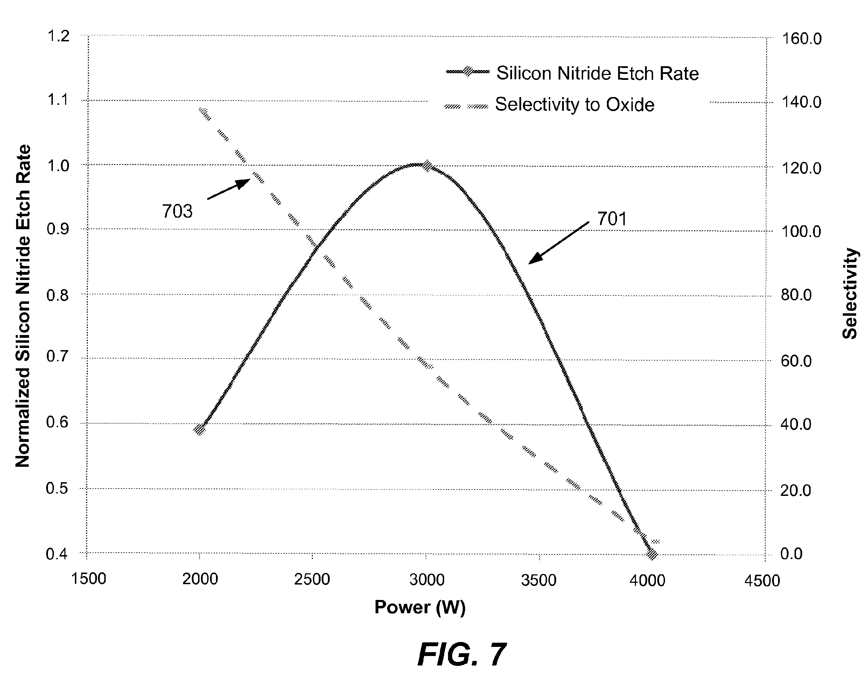

An experiment was conducted to evaluate the etch rate and etch selectivity of silicon nitride relative to plasma power. Substrates with silicon nitride and TEOS-deposited silicon oxide were provided to a process chamber. In each trial, the substrate was exposed to nitrous oxide (N₂O), oxygen (O₂), and tetrafluorocarbon (CF₄) with a plasma. Plasmas were operated at powers of 2000W, 3000W, and 4000W. The results are plotted in Figure 7. The curve 701 depicts the normalized silicon nitride etch rate relative to power. Note that at 2000W and 4000W, the etch rate was much lower than at 3000W. The curve 703 depicts the etch selectivity to oxide relative to power. Here, as power increases, etch selectivity decreases. The results of this experiment suggest that a balance between etch rate and selectivity is used by toggling power to obtain both a high etch rate and high etch selectivity to silicon oxide.

### EXPERIMENT 3: ADDITION OF CHₓF_{y}

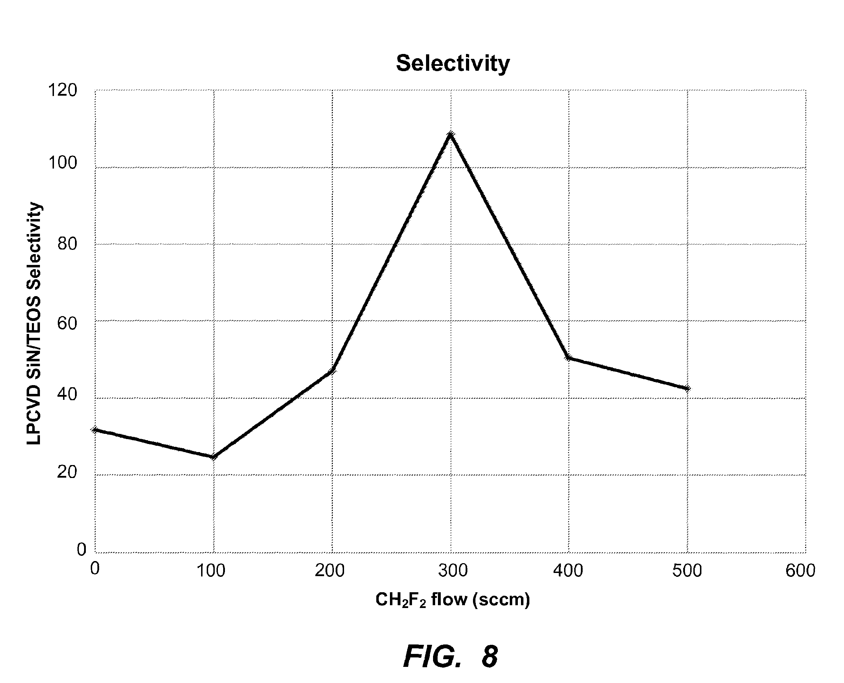

Experiments were conducted to evaluate the effect of adding a hydrogen-containing fluorocarbon to the silicon nitride etch process. The experiments involved substrates with silicon nitride and silicon oxide, and substrates with silicon nitride and polysilicon. In each trial, the substrate was exposed to nitrous oxide (N₂O), oxygen (O₂), tetrafluorocarbon (CF₄) with a plasma, as well as difluoromethane (CH₂F₂). Figure 8 shows the results of etch selectivity to silicon oxide deposited using TEOS relative to CH₂F₂ flow rate. As shown, the highest etch selectivity was achieved at a flow rate of about 300 sccm.

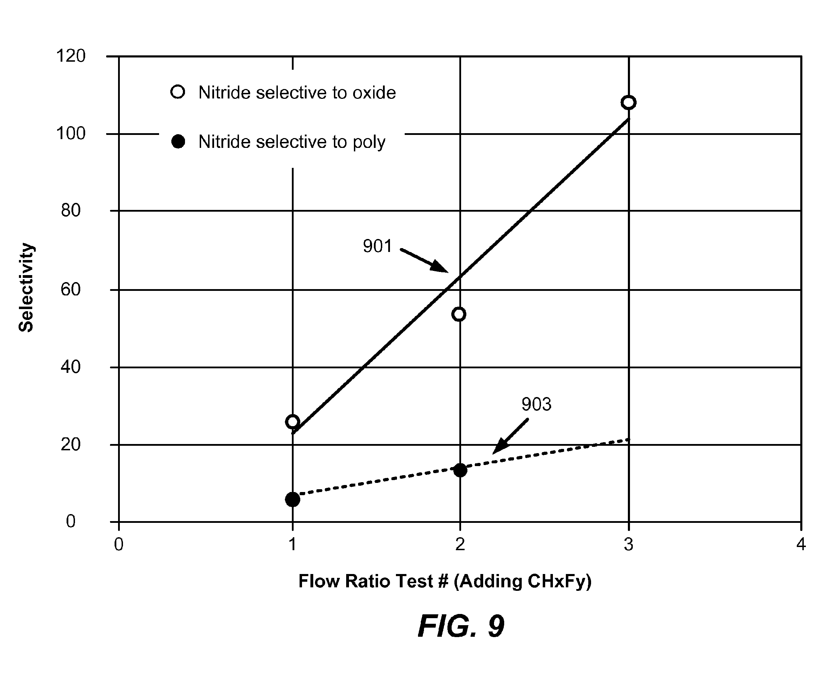

Figure 9 shows results of etch selectivity to silicon oxide (901) and etch selectivity to polysilicon (903) relative to flow rate ratios. Flow rates of CH₂F₂ for 1, 2 and 3 are 100 sccm, 200 sccm, and 300 sccm, respectively. The results are also shown in Table 1 below.

**Table 1. Etch Selectivity of SiN to SiO and Polysilicon with CHₓF_{y} Addition**

| **Process** | **Selectivity to Oxide** | **Selectivity to Poly** |
|---|---|---|
| **No CHₓF_{y} Added** | 27 | 7 |
| **200 sccm CHₓF_{y} flow** | 54 | 14 |
| **300 sccm CHₓF_{y} flow** | 109 | No Data |

Etch selectivities greater than 50:1 were achieved by adding a hydrogen-containing fluorocarbon.

### EXPERIMENT 4: TEMPERATURE

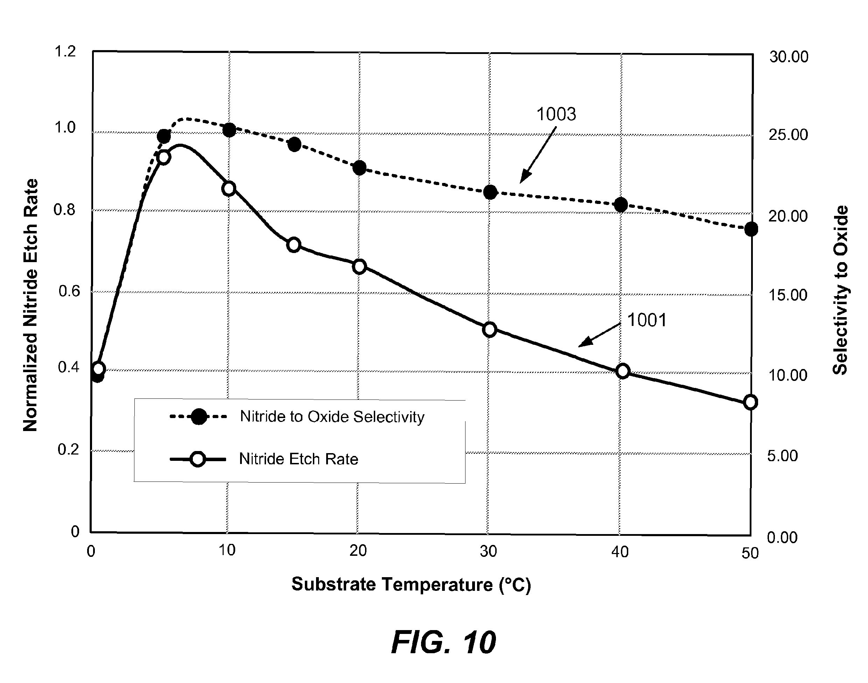

An experiment was conducted to evaluate the etch rate and etch selectivity of silicon nitride relative to TEOS-deposited silicon oxide with respect to substrate temperature. Substrates with silicon nitride and thermal silicon dioxide were provided to a process chamber. In each trial, the substrate was exposed to nitrous oxide (N₂O), oxygen (O₂), and tetrafluorocarbon (CF₄) with a plasma. The results are plotted in Figure 10. The curve 1001 depicts the normalized silicon nitride etch rate relative to temperature. Note that etch rate peaks at around 10°C, but temperatures near 0°C yielded a low etch rate, and etch rate steadily decreased as wafer temperature increased. The curve 1003 depicts the etch selectivity to thermal silicon dioxide relative to temperature. Like etch rate, selectivity peaked around 5-10°C, but was very low at 0°C, and steadily decreased as wafer temperature increased beyond 15°C. These results suggest that etch rate and selectivity are highest at around 10°C.

### EXPERIMENT 5: DEFLUORINATION

An experiment was conducted to determine the effect of defluorinating the substrate after etching silicon nitride and prior to turning the plasma off. Substrates with silicon nitride and silicon oxide were provided to a process chamber. One substrate was exposed to nitrous oxide (N₂O), oxygen (O₂), and tetrafluorocarbon (CF₄) with a plasma, and then the plasma was turned off without defluorinating. A second substrate was exposed to nitrous oxide (N₂O), oxygen (O₂), and tetrafluorocarbon (CF₄) with a plasma, and then the substrate was defluorinated by running a plasma of N₂O and O₂ with substrate RF bias for 45 seconds prior to turning the plasma off. The silicon nitride etch rate was evaluated for both substrates as shown in Table 2 below, and the selectivity to oxide was calculated. Note that with defluorination, the etch selectivity to oxide was at least 200 or more.

**Table 2. Defluorination After SiN Etch**

| **Condition** | **SiN Etch Rate** (nm/min) | **Selectivity to Oxide** |
|---|---|---|
| NO + CF₄ No defluorination step | 95-100 | 40-70 |
| NO + CF₄ With defluorination | 95-100 | 200 - infinite |

### CONCLUSION

Although the foregoing embodiments have been described in some detail for purposes of clarity of understanding, it will be apparent that certain changes and modifications may be practiced within the scope of the appended claims. It should be noted that there are many alternative ways of implementing the processes, systems, and apparatus of the present embodiments. Accordingly, the present embodiments are to be considered as illustrative and not restrictive, and the embodiments are not to be limited to the details given herein.

## Claims

1. A method of etching silicon nitride on a substrate, the method comprising:
(a) introducing nitrous oxide (N₂O), oxygen (O₂), and a fluorinating gas and igniting a plasma to form an etching species; and
(b) exposing silicon nitride to the etching species to selectively etch the silicon nitride relative to other silicon-containing materials on the substrate.

2. The method of claim 1, wherein the fluorinating gas comprises one or more gases having the formula CHₓF_{y}; and wherein x and y are integers between and including 0 and 4, and x + y = 4; or
wherein the ratio of the oxygen to the nitrous oxide is between about 0.75:1 and about 1:1.5; or
wherein the amount of fluorinating gas introduced is about 10% or less of the total gas flow; or
further comprising (c) introducing nitric oxide (NO) to the plasma.

3. The method of claim 1, further comprising (c) flowing a silicon-containing compound

4. The method of claim 3, wherein the silicon-containing compound is selected from the group consisting of silane, tetrachlorosilane, tetrafluorosilane, tetraethyl orthosilicate, disilane, and tetramethylsilane; or
wherein the partial pressure of the silicon-containing compound is less than about 10% of the pressure of a chamber housing the substrate.

5. The method of claim 1, further comprising (c) defluorinating the substrate.

6. The method of claim 5, wherein defluorinating the substrate further comprises purging a chamber housing the substrate with a purge gas;
preferably, wherein the purge gas is selected from the group consisting of argon, nitrogen, helium, neon, krypton, and xenon.

7. The method of claim 5, wherein defluorinating the substrate comprises flowing a scavenging gas; preferably, wherein the scavenging gas is selected from the group consisting of nitrous oxide (N₂O), nitric oxide (NO), nitrogen (N₂), carbon dioxide (CO₂), carbon monoxide (CO), oxygen (O₂), ammonia gas (NH₃), and combinations thereof.

8. The method of claim 5, wherein defluorinating the substrate comprises turning on and leaving on, or pulsing an RF bias; or
wherein defluorinating the substrate comprises generating a plasma of nitrous oxide (N₂O) gas and oxygen (O₂) in the absence of a fluorinating gas; or
further comprising after defluorinating the substrate, introducing an oxygen-containing gas.

9. The method of claim 1, further comprising repeating (a) and (b); or
wherein the process temperature is between about 0°C and about 80°C; or
wherein etch selectivity of silicon nitride to dielectric is at least about 100:1; or
wherein the other silicon-containing materials are selected from the group consisting of silicon dioxide, silicon oxide, silicon oxy-nitride, carbon doped silicon oxide and silicon.

10. A method of etching a substrate, the method comprising:
exposing the substrate to nitric oxide (NO) and a fluorinating gas and igniting a plasma to etch silicon nitride on the substrate; and
defluorinating the substrate.

11. The method of claim 10, wherein the amount of the fluorinating gas introduced is about 10% or less of the total gas flow.

12. The method of claim 11, wherein defluorinating the substrate further comprises purging a chamber housing the substrate with a purge gas; preferably, wherein the purge gas is selected from the group consisting of argon, nitrogen, helium, neon, krypton, and xenon.

13. The method of claim 11, wherein defluorinating the substrate comprises flowing a scavenging gas; preferably, wherein the scavenging gas is selected from the group consisting of nitrous oxide, nitric oxide, nitrogen, carbon dioxide, carbon monoxide, oxygen, ammonia gas, and combinations thereof.

14. The method of claim 10, wherein defluorinating the substrate comprises maintaining a plasma of nitric oxide in the absence of a fluorinating gas; or
wherein defluorinating the substrate comprises turning on an RF bias; or
further comprising after defluorinating the substrate, introducing an oxygen-containing gas; or
wherein nitric oxide is generated by reacting nitrous oxide (N₂O) and oxygen (O₂) and igniting a plasma; or
wherein nitric oxide is generated by reacting nitrogen (N₂) and oxygen (O₂) and igniting a plasma; or
wherein the fluorinating gas comprises one or more gases having the formula CHₓF_{y}; and wherein x and y are integers between and including 0 and 4, and x + y = 4.

15. An apparatus for processing semiconductor substrates, the apparatus comprising:
(a) one or more process chambers, each chamber comprising a showerhead and a pedestal;
(b) one or more gas inlets into the process chambers and associated flow-control hardware;
(c) a plasma generator; and
(d) a controller having at least one processor and a memory, the memory comprising computer-executable instructions for:
(i) introducing nitrous oxide (N₂O), oxygen (O₂), and one or more fluorinating gases to at least one of the one or more process chambers, and
(ii) igniting a plasma.

16. The apparatus of claim 15, wherein the plasma generator is a remote plasma generator; or wherein the pedestal further comprises an electrostatic chuck; or
wherein the computer-executable instructions for introducing the nitrous oxide, the oxygen, and the one or more fluorinating gases comprise instructions for flowing oxygen and nitrous oxide at a ratio between about 0.75:1 and about 1:1.5; or
wherein the memory further comprises computer-executable instructions for flowing a silicon-containing compound; or
wherein the memory further comprises computer-executable instructions for introducing nitric oxide (NO) to the plasma; or
wherein the memory further comprises computer-executable instructions for turning off the flow of the one or more fluorinating gases; or
wherein the memory further comprises computer-executable instructions for purging the chamber with a purge gas prior to turning off the plasma; or
wherein the memory further comprises computer-executable instructions for flowing a scavenging gas prior to turning off the plasma; or
wherein the memory further comprises computer-executable instructions for turning on an RF bias prior to turning off the plasma; or
wherein the memory further comprises computer-executable instructions for introducing an oxygen-containing gas prior to turning off the plasma.
